(19) Europäisches Patentamt
European Patent Office
Office européen des brevets

(11) **EP 1 746 427 B1**

(12) **EUROPEAN PATENT SPECIFICATION**

(45) Date of publication and mention
of the grant of the patent:
**09.01.2008 Bulletin 2008/02**

(51) Int Cl.:
***G01R 23/16*** *(2006.01)*

(21) Application number: **05015952.4**

(22) Date of filing: **22.07.2005**

(54) **Method and apparatus for spectral estimations adapted to non-uniformities of sampling**

Für unregelmäßiges Abtasten geeignetes Verfahren und Vorrichtung zur Spektralschätzung

Méthode et appareil pour des évaluations spectrales adaptées à l'échantillonnage non-uniforme

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**24.01.2007 Bulletin 2007/04**

(73) Proprietor: **Institute of Electronics and Computer Science of**
**Latvian University**
**Riga, LV-1006 Latvia (LV)**

(72) Inventors:
• **Bilinskis, Ivars**
 **1006 Riga (LV)**
• **Artjuhs, Jurijs**
 **1006 Riga (LV)**
• **Ribakovs, Aleksandrs**
 **1039 Riga (LV)**

(74) Representative: **Klickow, Hans-Henning**
**Jessenstrasse 4**
**22767 Hamburg (DE)**

(56) References cited:
**EP-A- 1 330 036** **US-A- 5 115 189**
**US-B1- 6 477 553**

• **BILINSKIS I ET AL: "DIGITAL ALIAS-FREE SIGNAL PROCESSING IN THE GHZ FREQUENCY RANGE" IEE COLLOQUIUM ON ADVANCED SIGNAL PROCESSING FOR MICROWAVE APPLICATIONS, IEE, LONDON, GB, 29 November 1996 (1996-11-29), pages 6-1, XP001133893**
• **YURI ARTYUKH, ET AL.: "Wideband RF Signal Digitising for High Purity Spectral Analysis" (SMMSP 2005) THE 2005 INTERNATIONAL WORKSHOP ON SPECTRAL METHODS AND MULTIRATE SIGNAL PROCESSING, JUNE 20-22 2005 IN RIGA, 22 June 2005 (2005-06-22), XP002357422**

**Description**

Field of the Invention

The present invention relates generally to the field of wideband analog signal digital spectral decomposition, analysis and reconstruction. More specifically the present invention is addressing the problem of improving alias-free wideband signal digitising and digital processing of the analog input signal adapted to the sampling non-uniformities in order to achieve high accuracy by reducing the errors due to the irregularities of the sampling process. The invention provides for quality of spectral estimations that is good enough for input signal reconstruction by means of inverse Fourier transforms and periodic resampling at frequency significantly higher than the mean sampling rate used at the initial signal digitising.

Statement of the Problem

For many of the analog-to-digital (A/D) converters the allowed upper frequency $F_{SM}$ of input analog signals considerably exceeds the maximal sampling rate $F_0$. For example, the bandwidth of A/D converter AD9433 from "Analog Devices, Inc." is 700 MHz wide. Therefore the upper frequency $F_{SM}$=700 MHz while the maximal sampling rate $F_0$=125 MHz. In the case of conventional uniform (periodic) sampling, the upper frequency of an input analog signal should be cut down to $F_0/2$ (Nyquist limit) to protect the digitized signal against aliasing. The aliasing is a well-known phenomenon of frequency overlapping when the digitized output signal bears no real relationship to the actual input signal. In the case of the above example, the upper frequency $F_{SM}$ of input analog signals should be limited to 62.5 MHz and that is 11 times less than this converter input bandwidth actually provides for. Therefore only a small part of the bandwidth resource of this A/D converter is exploited even when the input signal is stationary and could be reconstructed from sample values taken over a long period of time. Under these conditions only the frequency overlapping or aliasing prevents exploitation of such A/D converters in the full frequency range of their input bandwidth in a wide application area.

However it is possible to avoid aliasing. It is known that signal sampling at predetermined non-uniformly spaced time instants allows to sample an analog signal without aliasing at the mean frequency $F_A$ essentially lower than $F_{SM}$ (see, for example, "Anti-aliasing dithered method and apparatus for low frequency signal sampling"; Patent USA #5,115,189 from 1992). In this case the allowable upper frequency $F_{SM}$ of input analog signals is limited mainly by the minimal time step $T$ of the sampling interval variation, so that $F_{SM}<2/T$.

US 6,477,553 describes a method for sampling a signal using algorithms that process an N dimensional Fourier of a multi-dimensional function using non-uniform samples of the D scale along with FFT.

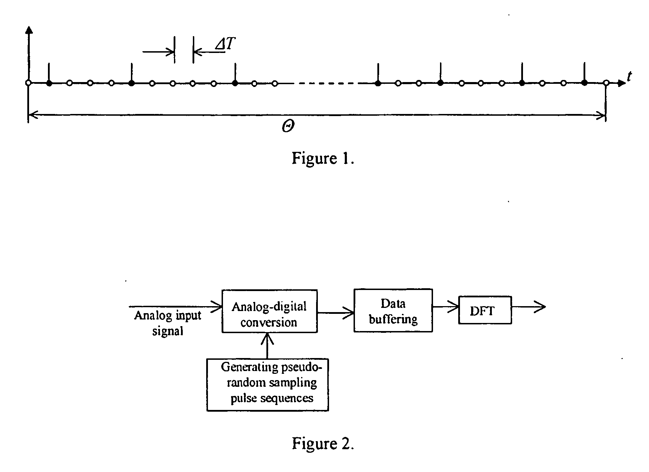

A typical non-uniform additive pseudo-random sampling pulse sequence used for performing alias-free signal sampling operation is shown in Figure 1. All sampling intervals in this sequence are statistically independent random values. As can be seen, in this case there are a number of empty slots of the grid for each filled one. That is the typical picture for many non-uniform sampling schemes. The point is that these variable sampling irregularities significantly influence processing of the sampled in this way signals. Specifically, these sampling non-uniformities determine the aliasing conditions. Note that while the considered non-uniform sampling ensure that aliasing could be eliminated, the quality of alias suppression depends also on the method how the sampled signal is processed. In the previous art case, illustrated by Figure 2, the spectral estimations are calculated on the basis of direct Digital Fourier Transform (DFT).

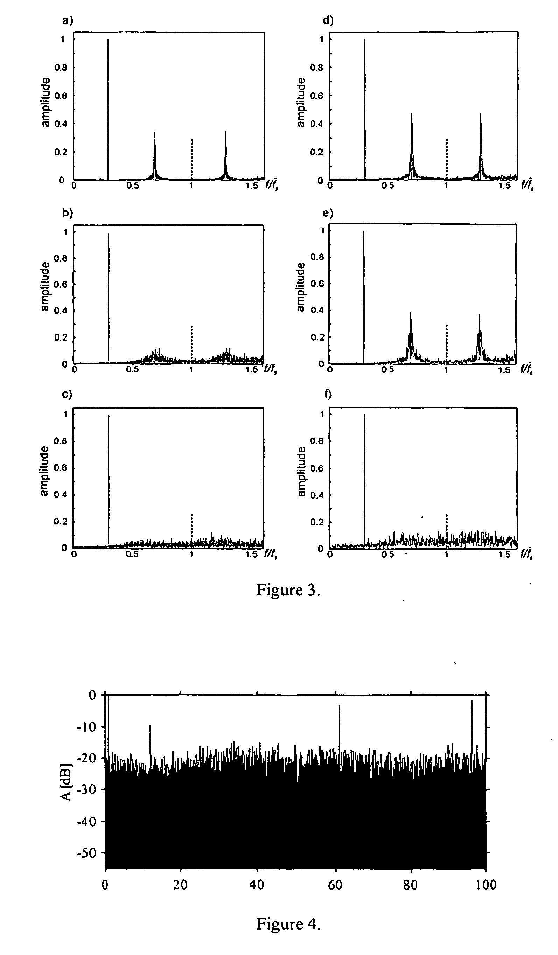

In this case, aliasing is more or less suppressed depending on the parameters of the sampling process. In general, aliasing becomes fuzzy then. While aliases are suppressed, aliasing occurs not only at the defined specific aliasing frequencies but it is washed out so that variously suppressed frequencies are overlapping within some frequency intervals. This is shown in Figure 3. The given spectrograms have been obtained for a single-tone signal. The signal comes out in the spectrograms as a peak. In the case of periodic sampling, there would be also other equally powerful peaks displaying the aliasing frequencies located symmetrically on both sides of the indicated sampling frequency. As the sampling is non-uniform, aliasing is more or less suppressed depending on the specific parameters of the sampling pulse process and the method used for spectral estimations. Spectrograms 3a, b, c have been obtained when the number of the processed signal sample values N=2048. Spectrograms 3d, e, f have been obtained when N=512. In the case of 3a and 3d, the ratio of standard deviation and the mean value of the sampling intervals $\delta/\mu$=0,03. For Figures 3b and 3e $\delta/\mu$=0,12 and $\delta/\mu$=0,061, respectively. As can be seen, aliasing is fully suppressed in the cases, illustrated by Figures 3c and 3f, when $\delta/\mu$=0,23.

However the quality of the alias suppression in the illustrated previous art case is not sufficiently high. Although increasing the deviation of the sampling intervals leads to elimination of aliases symmetrical to the mean sampling frequency, background noise, proportional to the signal amplitude, appears and it is significant. It might be said that aliasing at well-defined frequencies is replaced by a wideband noise. Due to this noise, spectral estimates calculated on the basis of DFT have relatively large errors.

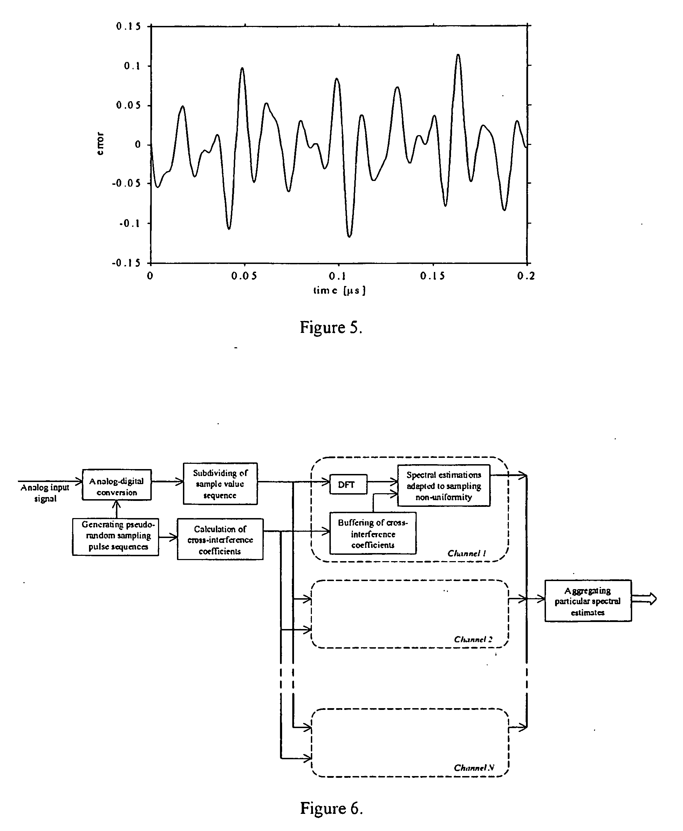

The point is that the each signal component impact estimation of all other components. In other words, cross-interference takes place. And the spectral estimation errors induced by this cross-interference effect are large. Figure 4 shows DFT result for multi-tone signal sampled at 40 MHz mean sampling rate minimal time step of the sampling interval variation equal to 5 ns. As can be seen, there is essential (about 20 dB) noise, resulting in essential error of input signal reconstruction. Figure 5 illustrates this error calculated as a difference between true and reconstructed signals. The error reaches +/- 12% approx.

Thus there are three main problems to be solved in order to significantly increase the accuracy of wideband signal alias-free spectral estimations:

1) how to ensure that aliases of non-uniformly sampled signals appear at well-defined frequencies;

2) how to perform spectral estimations without errors due to the cross-interference effect;

3) how to take out the aliases without introducing spectral estimation errors at other frequencies.

**SOLUTION TO THE PROBLEM**

The problem is solved by the method according to claim 1 and the apparatus according to claim 2.

The present invention addresses these problems by processing digital presentation of analog signal by means of the subdividing a signal sample value sequence into periodic pseudo-randomly decimated sub-sequences, Digital Fourier Transform (DFT) of each sub-sequence, calculation of cross-interference coefficients, spectral estimating adapted to the sampling non-uniformity and aggregating the particular sets of Fourier coefficient estimates. The spectral estimating is performed in form of sequential calculations where each calculation includes error iteration based on said pre-calculation of cross-interference coefficients, subtraction the error from the result of said DFT, and using subtraction result for next calculation. This results in increasing the accuracy of wideband signal alias-free spectral estimations.

**DETAILED DESCRIPTION OF THE INVENTION**

In the drawings there is shown an example of the invention and some additionally background informations. The drawing are showing in detail:

Fig. 1    A typical non-uniform additive pseudo-random sampling pulse sequence,

Fig. 2    a previous art case, calculations of spectral estimates on the basis of direct Digital Fourier Transforms,

Fig. 3    Fuzzy aliasing occurring when nonuniformly sampled signals are processed directly by using DFT,

Fig. 4    DFT result for multi-tone non-uniformly sampled signal,

Fig. 5    Reconstruction error normalized to the input signal amplitude,

Fig. 6    Block-diagram of the present invention,

Fig. 7    Obtaining partial pseudo-randomly decimated phase shifted periodic streams of sampling pulses by pulse selection from the basic pseudorandom stream of the sampling pulses given below,

Fig. 8    Spectrograms obtained in the case when sample values of a single-tone signal are taken periodically with some of them pseudo-randomly skipped; a- N=2048 ; b- N=512,

Fig. 9    Detailed block diagram of the functional unit for adapting signal spectrum estimations to the specific sampling non-uniformities given as cross-interference coefficients,

Fig. 10    Spectrum of multi-tone non-uniformly sampled signal for the present invention and

Fig. 11    Reconstruction error normalized to the input signal amplitude for the present invention

Figure 6 illustrates the present invention. To convert the input signal into the digital format and ensure that the digital signal could be processed in an alias-free way, it is sampled non-uniformly at instants according to the generated additive pseudorandom time instant sequence shown in Figure 1.

The present method for processing the non-uniformly digitised signals contains the following procedures aimed to resolution of the identified above problems:

1. Subdividing the signal sample value sequences into periodic pseudo-randomly decimated sub-sequences.

2. Adapting the calculation of particular sets of Fourier coefficient estimates to sampling non-uniformities for each signal sample value sub-set.

3. Aggregating the particular sets of Fourier coefficient estimates for obtaining the alias-free spectral estimates of the input signal.

**A. Subdividing the signal sample value sequences into periodic pseudo-randomly decimated sub-sequences.**

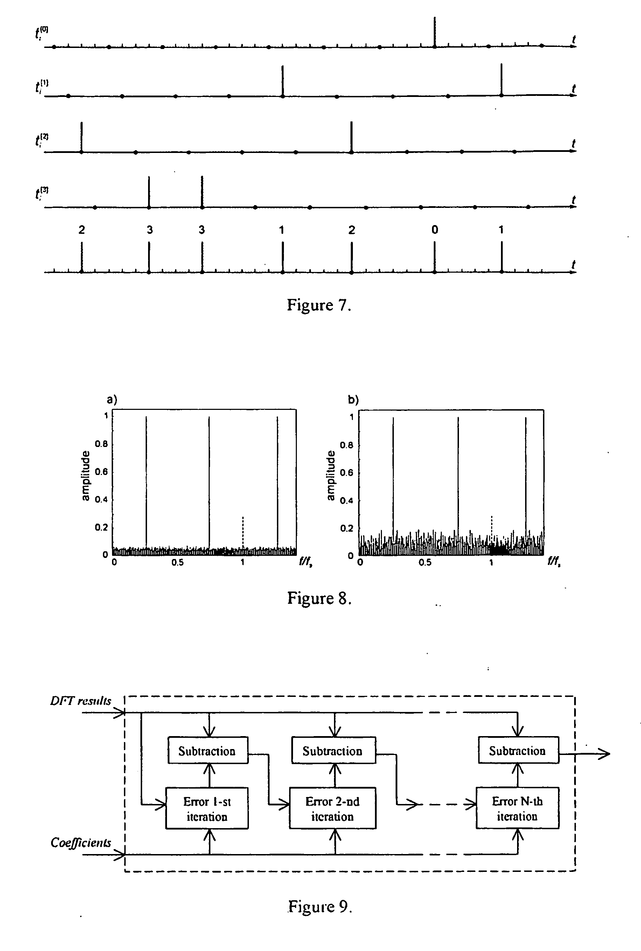

To resolve the first of the indicated problems, to avoid fuzzy aliasing, the typical nonuniform sampling point (sampling instant) process of Figure 1 is decomposed into a number of periodic sampling pulse processes with pseudo-randomly skipped sampling instants as shown in Figure 7. The sampling instant sequence is considered as consisting of z periodic phase-shifted processes. All of these periodic processes have equal period T and each one of them is phase-shifted by a phase increment T/z. The time period T should be equal or longer than the period of the highest sampling frequency for the ADC to be used. Each sampling instant in the initial sampling pulse sequence is marked as belonging to a specific periodic sampling point process. As can be seen, this sampling scheme is hybrid as it is the product of mixing periodic phase-shifted sampling with pseudorandom procedure of picking out sampling instants from these periodic sampling pulse streams.

Such subdivision of the total sampling pulse process into components as described improves the quality of signal processing substantially. To explain why this hybrid sampling method is better than the method for non-uniform sampling based on usage of the mentioned additive pseudorandom sampling process, the aliasing relationships for the periodic sampling pulse streams with pseudo-random skips and the impact of phase shifting of a periodic sampling point process on conditions of aliasing have to be taken into account.

First, aliasing for the periodic sampling pulse streams with pseudo-random skips is well-defined. Spectrograms of Figure 8 illustrate that. As can be seen, the aliases are located symmetrically to the sampling frequency and their amplitudes are equal to the amplitude of the signal. However, the noise due to the cross-interference is still present.

Second, these well-defined aliases could be taken out at spectral estimations by aggregating data obtained by calculating spectral estimates for all particular data streams.

To realize how that could be done, impact of phase-shifting of the sampling pulse sequences on the aliasing conditions has to be taken into account. The point is that conditions for frequency overlapping or aliasing essentially depend not only on the sampling frequency but also on the sampling phase. Therefore the estimates of signal components in the frequency domain differ depending on the phase shift of the corresponding periodic sampling instant process. The fact that the phase angle of the signal, downconverted due to aliasing, depends on the phase of the sampling point process is exploited for eliminating the aliases at the stage of aggregating the data. The particular z sets of the Fourier coefficient estimates, obtained by processing the signal sample value z subsets, are used for calculation of the final alias-free characteristics of the input signal spectrum.

**B. Adapting the calculation of particular sets of Fourier coefficient estimates to sampling non-uniformities for each signal sample value sub-set.**

The pattern of the missing sampling pulses in the periodic sampling pulse streams determines the errors introduced by skipping them. However, at purposeful deliberate pseudo-randomisation of sampling, this pattern is given. Therefore this information might be used to suppress these errors. The problem is that they are both sampling and signal dependent. The invented method uses a procedure for improving the accuracy of spectral estimations by adapting the calculation of the Fourier coefficient estimates to these sampling non-uniformities. The method is applicable for processing a wide variety of signals that could be considered as composed from M sinusoidal components, each characterised by its frequency, amplitude and phase angle.

Estimation of the Fourier coefficients for signal $x(t_k)$ on frequency $f_i$ is performed on the basis of the usually applied formulae:

$$\hat{a}_i = \frac{2}{N} \sum_{k=0}^{N-1} x(t_k) \cos(2\pi f_i t_k)$$

$$\hat{b}_i = \frac{2}{N} \sum_{k=0}^{N-1} x(t_k) \sin(2\pi f_i t_k)$$

The problem is that these estimates are corrupted by errors due to cross-interference between signal components caused by the irregularities of the sample taking process. To take these errors out, coefficients characterising interference between signal components due to the non-uniformities of the sampling process are introduced. They are defined as

$$(A_i C_m) = \frac{2}{N} \sum_{k=0}^{N-1} \cos(2\pi f_m t_k) \cos(2\pi f_i t_k)$$

$$(A_i S_m) = \frac{2}{N} \sum_{k=0}^{N-1} \sin(2\pi f_m t_k) \cos(2\pi f_i t_k)$$

$$(B_i C_m) = \frac{2}{N} \sum_{k=0}^{N-1} \cos(2\pi f_m t_k) \sin(2\pi f_i t_k)$$

$$(B_i S_m) = \frac{2}{N} \sum_{k=0}^{N-1} \sin(2\pi f_m t_k) \sin(2\pi f_i t_k)$$

These coefficients indicate the impact of the sampling imperfections. Actually they are the weights of the errors introduced by sampling non-uniformities of the present in the signal a sine (or cosine) component at frequency $f_m$ corrupting estimation of a Fourier coefficient $a_i$ (or $b_i$) at frequency $f_i$.
As follows from these definitions,

$$A_i C_m = A_m C_i$$

$$A_i S_m = B_m C_i$$

$$B_i C_m = A_m S_i$$

$$B_i S_m = B_m S_i$$

The coefficient matrix is given as

$$C = \begin{bmatrix} (A_1C_1) & (A_1S_1) & (A_1C_2) & (A_1S_2) & ... & (A_1S_M) & (A_1S_M) \\ (B_1C_1) & (B_1S_1) & (B_1C_2) & (B_1S_2) & ... & (B_1C_M) & (B_1S_M) \\ (A_2C_1) & (A_2S_1) & (A_2C_2) & (A_2S_2) & ... & (A_2S_M) & (A_2S_M) \\ (B_2C_1) & (B_2S_1) & (B_2C_2) & (B_2S_2) & ... & (B_2C_M) & (B_2S_M) \\ ... & ... & ... & ... & ... & ... & ... \\ (A_iC_1) & (A_iS_1) & (A_iC_2) & (A_iS_2) & ... & (A_iC_M) & (A_iS_M) \\ (B_iC_1) & (B_iS_1) & (B_iC_2) & (B_iS_2) & ... & (B_iC_M) & (B_iS_M) \end{bmatrix}$$

Matrix of the given coefficients is a very important characteristic of the respective periodic sampling point process with random skips. Once the pattern of the missing sampling points, determined by the pseudo-random number generator used at forming the sampling pulse sequence, is known, all coefficients of matrix $C$ are calculated. Then they are used for elimination of the errors due to the described cross-interference caused by sampling point skipping.

In general, the number of signal components might exceed the number of signal sample values of a particular periodic sampling subset. Then an iterative procedure has to be used for adapting the calculation of particular sets of Fourier coefficient estimates to sampling non-uniformities for each signal sample value sub-set as shown in Figure 9.

Apparently the differences between the true and estimated values of Fourier coefficients are errors. While there are various error components caused by quantisation errors, external noise etc., the errors due to the sampling non-uniformities considered here are dominating. The error of estimating the Fourier coefficients at a frequency $i$ are proportional to the amplitude of the interfering quadratic components at the frequency $j$ multiplied by the corresponding cross-interference coefficient. In general, it might be written that these errors of estimating coefficients $a_i$, $b_i$ depend on the amplitudes of all other quadratic components $a_j$, $b_j$ of the signal at their respective frequencies $f_j$:

$$\varepsilon_{ij}(a_i, b_i) = \begin{cases} A_iC_ja_j; & A_iS_ja_j; \\ B_iC_jb_j; & B_iS_jb_j; \end{cases}$$

However the true values $a_i, b_i$ are not known. Only their DFT-estimates $\hat{a}_i, \hat{b}_i$ are given. Nevertheless they make it possible to calculate the approximation of the estimation errors

$$\varepsilon_{ij}^{(1)}(a_i, b_i) = \begin{cases} A_iC_j\hat{a}_j; & A_iS_j\hat{a}_j; \\ B_iC_j\hat{b}_j; & B_iS_j\hat{b}_j; \end{cases}$$

These errors are subtracted from DFT-estimates $\hat{a}_i, \hat{b}_i$ and the first set of the improved estimates $a_i^{(1)}$, $b_i^{(1)}$ are obtained as shown in Figure 9.

For the next iteration step, the estimation error

$$\varepsilon_{ij}^{(2)}(a_i, b_i) = \begin{cases} A_iC_ja_j^{(1)}; & A_iS_ja_j^{(1)}; \\ B_iC_jb_j^{(1)}; & B_iS_jb_j^{(1)}; \end{cases}$$

is calculated and then the iteration is made. This iterative process is continued for a number of times. For $k+1$ iteration step

$$\varepsilon_{ij}^{(k+1)}(a_i, b_i) = \begin{cases} A_i C_j a_j^{(k)}; & A_i S_j a_j^{(k)}; \\ B_i C_j b_j^{(k)}; & B_i S_j b_j^{(k)}; \end{cases}$$

where the improved estimates $a_i^{(k)}$, $b_i^{(k)}$ *are* obtained at the previous k-th iteration step. The obtained estimates of Fourier coefficients for each and all sampling pulse sub-streams, are adapted to the sampling nonuniformities in this way. They are significantly more precise than the initially used raw estimates obtained directly in result of application of DFT. The obtained improved estimates represent data for further signal processing.

**C. Data aggregating for alias-free estimations of Fourier coefficients**

Data representing estimates of Fourier coefficients, calculated in the frequency range $0 - 0.5\,f_s$ for each multitude of the signal sample values under conditions of 100% aliasing, are to be aggregated for obtaining alias-free estimates of Fourier coefficients in the whole frequency range defined by the phase shift value of the sampling pulse sub-streams.
without loss of the generality, the specific equations are given below that have to be used for spectral estimations in the case where the common sampling point stream is subdivided into 4 sub-streams. The phase shift between separate sampling pulse sub-streams is then equal to ¼ T. Therefore the highest frequency of the signal might exceed two times the frequency of the periodic sampling point processes used. After the signal sample values are subdivided into 4 subsets, each of them is processed separately in the Nyquist frequency band *0 - 0.5 $f_s$*. Each of the signal basic frequencies $f_0$ within the frequency band *0 - 0.5 $f_s$* has respective three potentially aliasing frequencies $f_1, f_2, f_3$. Spectral estimations of the signal components in the whole frequency range *0 - 2$f_s$* have to be made. Accuracy of estimation the Fourier coefficients for all signal components in the whole frequency range depends on the accuracy of estimating of $a_0^{[m]}$ and $b_0^{[m]}$ for all four *(m=0,1,2,3)* mentioned sampling subroutines. The values of $a_i^{[0]}, b_i^{[0]}$, $a_i^{[1]}, b_i^{[1]}$, $a_i^{[2]}, b_i^{[2]}$, $a_i^{[3]}, b_i^{[3]}$ are calculated by applying the DFT procedure and then these estimates are improved by adapting them to the specific sampling non-uniformities as explained above. After that, the obtained data have to be used for obtaining the improved estimates of the signal components in the whole bandwidth.
The following system of equations is used for that:

$$a(f_i) = \frac{1}{4}\left(a_i^{[0]} + a_i^{[1]} + a_i^{[2]} + a_i^{[3]}\right)$$

$$b(f_i) = \frac{1}{4}\left(b_i^{[0]} + b_i^{[1]} + b_i^{[2]} + b_i^{[3]}\right)$$

$$a(f_s - f_i) = \frac{1}{4}\left(a_i^{[0]} + b_i^{[1]} - a_i^{[2]} - b_i^{[3]}\right)$$

$$b(f_s - f_i) = \frac{1}{4}\left(-b_i^{[0]} + a_i^{[1]} + b_i^{[2]} - a_i^{[3]}\right)$$

$$a(f_s + f_i) = \frac{1}{4}\left(a_i^{[0]} - b_i^{[1]} - a_i^{[2]} + b_i^{[3]}\right)$$

$$b(f_s + f_i) = \frac{1}{4}\left(b_i^{[0]} + a_i^{[1]} - b_i^{[2]} - a_i^{[3]}\right)$$

$$a(2f_s - f_s) = \frac{1}{4}\left(a_i^{[0]} - a_i^{[1]} + a_i^{[2]} - a_i^{[3]}\right)$$

$$b(2f_s - f_i) = \frac{1}{4}\left(-b_i^{[0]} + b_i^{[1]} - b_i^{[2]} + b_i^{[3]}\right)$$

Now Fourier coefficients of all signal components at frequencies within the frequency bands 0- $0.5f_s$; $0.5f_s$ - $f_s$; $f_s$ - $1.5f_s$; $1.5f_s$ - $2f_s$; are explicitly expressed through the amplitudes of the quadratic components of the sine functions filtered out within the frequency range $0$ - $0.5f_s$. Thus the alias-free spectrum of the input signal is obtained more precisely than in the previous art cases as the estimation process is adapted to the specific sampling non-uniformities.

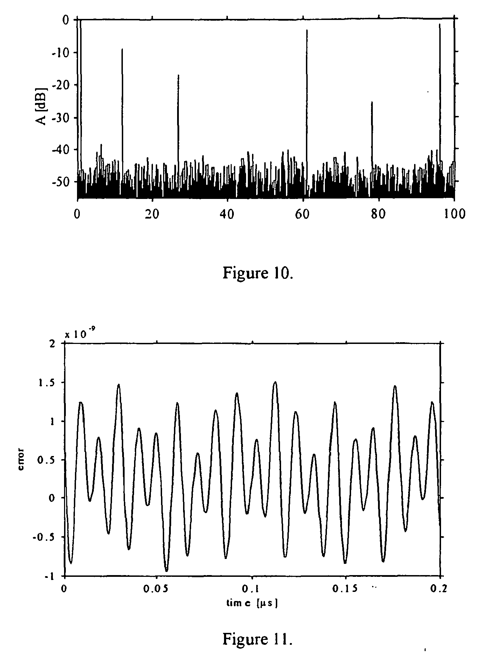

Figures 10 and 11 illustrate advantages of the invented solution in comparison with the processing results (see Figures 4 and 5) obtained in usual way. The input signal is the same. As can be seen from Figures 10, the noise is significantly smaller. This results in negligibly small error of signal reconstruction (Figure 11).

**Claims**

1. A method for spectral estimations adapted to non-uniformities of sampling, said method comprising:

   sampling an analog signal at non-uniformly spaced instant;
   processing digital presentation of said analog signal by the following steps:

   (a) subdividing a signal sample value sequence into periodic pseudo-randomly decimated sub-sequences;
   (b) Digital Fourier Transform (DFT) of each sub-sequence;
   (c) pre-calculation of cross-interference coefficients characterizing interference between signal components due to nonuniformities of the sampling process;
   (d) spectral estimating adapted to the sampling non-uniformity, wherein said spectral estimating is performed in form of sequential calculations where each calculation includes error iteration based on said pre-calculation of cross-interference coefficients, subtraction the error from the result of said DFT, and using subtraction result for next calculation;
   (e) aggregating the particular sets of Fourier coefficient estimates.

2. An apparatus for spectral estimations adapted to non-uniformities of sampling, said apparatus comprising:

   means for sampling an analog signal at non-uniformly spaced instant;
   means for processing digital presentation of said analog signal by following means:

   (a) means for subdividing a signal sample value sequence into periodic pseudo-randomly decimated sub-sequences;
   (b) means for Digital Fourier Transform (DFT) of each sub-sequence;
   (c) means for pre-calculation of cross-interference coefficients characterizing interference between signal components due to nonuniformities of the sampling process;
   (d) means for spectral estimating adapted to the sampling non-uniformity, wherein said spectral estimating is performed in form of sequential calculations where each calculation includes error iteration based on said pre-calculation of cross-interference coefficients, subtraction the error from the result of said DFT, and using subtraction result for next calculation;
   (e) means for aggregating the particular sets of Fourier coefficient estimates.

**Patentansprüche**

1. Verfahren zur Durchführung von Spektralabschätzungen, das an Ungleichmäßigkeiten einer Abtastung angepaßt ist, wobei das Verfahren die folgenden Schritte aufweist:

   - Abtasten eines Analogsignals zu ungleichmäßig beabstandeten Zeitpunkten;
   - Verarbeitung einer digitalen Darstellung des Analogsignals durch die folgenden Schritte:

(a) Unterteilung einer Folge von Signalabtastwerten in verminderte periodische Pseudo-Zufalls-Unterfolgen;

(b) Durchführung einer digitalen Fouriertransformation (DFT) jeder Unterfolge;

(c) Vorberechnung von Kreuz-Interferenz-Koeffizienten, die eine Interferenz zwischen Signalkomponenten charakterisieren in Abhängigkeit von Ungleichmäßigkeiten des Abtastvorganges;

(d) Spektrale Abschätzung angepaßt zur Ungleichmäßigkeit der Abtastung, wobei die spektrale Abschätzung in Form von sequentiellen Berechnungen durchgeführt wird, wobei jede Berechnung eine Fehlerbestimmung beinhaltet, die auf der Vorberechnung der kreuzweisen Interferenzquoeffizienten basiert, abziehen des Fehlers vom Ergebnis der DFT und Verwendung des Subtraktionsergebnisses für die nächste Berechnung;

(e) Zusammenfassen der einzelnen Sets von ermittelten Fourierkoeffizienten.

2. Vorrichtung zur Durchführung von spektralen Abschätzungen angepaßt an Ungleichmäßigkeiten der Abtastung, wobei die Vorrichtung umfaßt:

- Mittel zur Abtastung eines Analogsignales zu ungleichmäßig beabstandeten Zeitpunkten;
- Mittel zur Verarbeitung einer digitalen Darstellung der Analogsignale durch Verwendung der folgenden Mittel:

(a) Mittel zur Unterteilung einer Folge von Abtastwerten des Signals in verminderte periodische Pseudo-Zufalls-Unterfolgen;

(b) Mittel zur Durchführung einer digitalen Fouriertransformation (DFT) jeder Unterfolge;

(c) Mittel zur Vorberechnung von Kreuz-Interferenz-Koeffizienten, die eine Interferenz zwischen Signalkomponenten charakterisieren in Abhängigkeit von Ungleichmäßigkeiten des Abtastvorganges;

(d) Mittel zur spektralen Abschätzung angepaßt an die ungleichmäßige Abtastung, wobei die spektrale Abschätzung in Form von sequentiellen Berechnungen durchgeführt wird, wobei jede Berechnung eine Fehlerbestimmung beinhaltet, die auf der Vorbestimmung der Kreuz-Interferenz-Koeffizienten basiert, Abziehen des Fehlers von Ergebnis der DFT und Verwendung des Subtraktionsergebnisses für die nächst Berechnung;

(e) Mittel zum Zusammenfassen der einzelnen Sets der abgeschätzten Fourierkoeffizienten.

**Revendications**

1. Procédé d'estimations spectrales adaptées aux non-uniformités d'un échantillon, ledit procédé comprenant :

l'échantillonnage d'un signal analogue à l'instant espacé de manière non uniforme ;
le traitement de la présentation digitale dudit signal analogue par les étapes suivantes :

(a) la subdivision d'une séquence de valeurs d'échantillon du signal en des sous-séquences périodiques, décimées de manière pseudo-statistique ;

(b) la transformée de Fourier digitale (DFT) de chaque sous-séquence ;

(c) le précalcul des coefficients d'interférence croisée caractérisant les interférences entre les composants du signal à cause des non-uniformités du processus d'échantillonnage ;

(d) l'estimation spectrale adaptée à la non-uniformité de l'échantillonnage, où la dite estimation spectrale est réalisée sous forme de calculs séquentiels, où chaque calcul comprend une itération d'erreur basée sur ledit pré-calcul des coefficients d'interférence croisée, la soustraction de l'erreur depuis le résultat de la DFT et l'utilisation du résultat de la soustraction pour le calcul suivant ;

(e) l'agrégation des ensembles particuliers des estimations du coefficient de Fourier.

2. Appareil pour des estimations spectrales adaptées aux non-uniformités de l'échantillonnage, ledit appareil comprenant :

des moyens d'échantillonnage d'un signal analogue à un instant espace de manière non uniforme ;
des moyens pour le traitement de la présentation digitale dudit signal analogue par les moyens suivants :

(a) des moyens pour subdiviser une séquence de valeurs d'échantillon du signal en des sous-séquences périodiques, décimées de manière pseudo-statistique ;

(b) des moyens pour la transformée de Fourier digitale (DFT) de chaque sous-séquence ;

(c) des moyens pour le pré-calcul des coefficients d'interférence croisée caractérisant l'interférence entre les composants du signal à cause des non-uniformités du processus d'échantillonnage ;

(d) des moyens pour l'estimation spectrale adaptée à la non-uniformité de l'échantillonnage, où la dite estimation spectrale est réalisée sous forme de calculs séquentiels, où chaque calcul comprend une itération d'erreur basée sur ledit pré-calcul des coefficients d'interférence croisée, la soustraction de l'erreur depuis le résultat de la DFT et l'utilisation du résultat de la soustraction pour le calcul suivant ;

(e) des moyens pour l'agrégation des ensembles particuliers des estimations du coefficient de Fourier.

Figure 1.

Figure 2.

Figure 3.

Figure 4.

Figure 5.

Figure 6.

Figure 7.

Figure 8.

Figure 9.

Figure 10.

Figure 11.

**EP 1 746 427 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5115189 A

- US 6477553 B